(19) **Europäisches Patentamt**
**European Patent Office**
**Office européen des brevets**

(11) **EP 2 311 086 B1**

(12) **FASCICULE DE BREVET EUROPEEN**

(45) Date de publication et mention
de la délivrance du brevet:
**09.11.2016 Bulletin 2016/45**

(51) Int Cl.:
*H01L 23/373* *(2006.01)*    *H01L 23/427* *(2006.01)*
*H01L 23/473* *(2006.01)*    *F28D 15/04* *(2006.01)*
*F28F 13/18* *(2006.01)*

(21) Numéro de dépôt: **09802526.5**

(22) Date de dépôt: **30.07.2009**

(86) Numéro de dépôt international:
**PCT/EP2009/059848**

(87) Numéro de publication internationale:
**WO 2010/012798 (04.02.2010 Gazette 2010/05)**

(54) **STRUCTURE D'ECHANGE THERMIQUE ET DISPOSITIF DE REFROIDISSEMENT COMPORTANT UNE TELLE STRUCTURE**

WÄRMETAUSCHERSTRUKTUR UND KÜHLVORRICHTUNG MIT DERARTIGER STRUKTUR

HEAT EXCHANGE STRUCTURE AND COOLING DEVICE INCLUDING SUCH A STRUCTURE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **01.08.2008 FR 0855336**

(43) Date de publication de la demande:
**20.04.2011 Bulletin 2011/16**

(73) Titulaire: **Commissariat à l'Énergie Atomique et aux Énergies Alternatives**
**75015 Paris (FR)**

(72) Inventeurs:
• **GAVILLET, Jérôme**
**38120 Saint-Egreve (FR)**
• **CANEY, Nadia**
**F-38120 Le Fontanil (FR)**
• **COLASSON, Stéphane**
**F-38340 Voreppe (FR)**
• **MARTY, Philippe**
**F-38410 Saint Martin d'Uriage (FR)**
• **PHAN, Hai Trieu**
**F-38000 Grenoble (FR)**

(74) Mandataire: **Ilgart, Jean-Christophe et al**
**BREVALEX**
**95, rue d'Amsterdam**
**75378 Paris Cedex 8 (FR)**

(56) Documents cités:
EP-A- 1 662 852    WO-A-2007/019558
US-A- 5 453 641    US-A1- 2004 238 160
US-A1- 2007 158 052    US-A1- 2007 235 847

• UJEREH ET AL: "Effects of carbon nanotubes on nucleate boiling" INTERNATIONAL JOURNAL OF HEAT AND MASS TRANSFER, vol. 50, 27 mars 2007 (2007-03-27), pages 4023-4038, XP002520035 cité dans la demande
• MA M ET AL: "Superhydrophobic surfaces" CURRENT OPINION IN COLLOID AND INTERFACE SCIENCE, LONDON, GB, vol. 11, no. 4, 1 octobre 2006 (2006-10-01), pages 193-202, XP024966927 ISSN: 1359-0294 [extrait le 2006-10-01]
• KRUPENKIN ET AL: "From Rolling Ball to Complete Wetting: The Dynamic Tuning of Liquids on Nanostructured Surfaces" LANGMUIR, vol. 2004, no. 20, 2 octobre 2004 (2004-10-02), pages 3824-3827, XP002520036
• KAMENOVA ET AL: "Conception and test of flat heat pipe for 3D packaging cooling" INDUSTRIAL ELECTRONICS 2007, 5 novembre 2007 (2007-11-05), pages 787-792, XP002520037 IEEE Xplore cité dans la demande

**Description**

**DOMAINE TECHNIQUE ET ART ANTÉRIEUR**

La présente invention se rapporte à une structure d'échange thermique améliorée, et un dispositif de refroidissement comportant une telle structure, par exemple un caloduc dont ladite structure forme l'évaporateur.

La miniaturisation des composants électroniques, et notamment des composants de puissance, pose le problème de l'intégration des dispositifs de dissipation de la chaleur émise par ces composants. Dans le domaine de la microélectronique et de l'électronique de puissance, les flux thermiques à dissiper sont de plus en plus élevés et nécessitent une réduction toujours plus grande de la résistance thermique. Les flux thermiques à évacuer ont souvent des valeurs moyennes autour de 150-200 W/cm$^2$, mais peuvent atteindre 1000 W/cm$^2$. Pour ces niveaux de densité de flux de chaleur, les méthodes de refroidissement dites passives, comme les dissipateurs à ailettes ou les systèmes liquides monophasiques atteignent rapidement leur limite de puissance à extraire.

D'autres solutions ont donc été imaginées comme les transferts de chaleur diphasiques liquide/vapeur. Les technologies mettant en oeuvre ces transferts sont le caloduc, le thermosiphon, les boucles capillaires ou à pompage diphasique. Le composant à refroidir est situé sur la zone froide du dispositif de refroidissement, i.e. l'évaporateur.

Une solution pour refroidir un composant électronique est la mise en oeuvre d'un caloduc qui absorbe la chaleur au niveau du composant et l'évacue vers l'extérieur, cette solution est notamment décrite dans le document «Conception and test of flat heat pipe for 3D packaging cooling» Lora Kamenova, Yvan Avenas, Nathaliya Popova, Christian Schaeffer, Slavka Tzanova, 1-4244-0755-9/07/2007 IEEE, p. 787-792.

Les caloducs permettent d'augmenter la conductivité thermique d'un dissipateur de chaleur. Les caloducs permettent le transfert d'une puissance thermique extraite d'une surface donnée vers une surface secondaire, souvent plus accessible ou offrant de meilleurs échanges de chaleur pour la dissipation. Le caloduc est un système clos dans lequel est placé un fluide liquide en équilibre avec sa vapeur. Le caloduc comporte une zone formant évaporateur du côté du composant électronique, où est absorbée la chaleur à dissiper par formation de vapeur. La vapeur produite à l'évaporateur migre à travers le coeur du caloduc jusqu'à une zone de condensation où la chaleur absorbée est relâchée par liquéfaction de la vapeur, la chaleur est donc évacuée. Le condensat retourne vers la zone d'évaporation grâce aux forces capillaires.

Le caloduc peut être rapporté sur le composant électronique ou intégré sur le composant, dans le cas des puces microélectroniques, cela consiste à implanter un réseau de canaux directement sur le substrat en silicium, réduisant ainsi la résistance thermique.

Une autre solution est la réalisation de thermosiphon, le fluide étant déplacé par gravité, l'évaporateur se trouvant en dessous du condenseur.

Une autre solution encore est le système de pompage diphasique utilisant un système moteur, un condenseur et un évaporateur.

Toutes ces solutions utilisent donc une surface d'échange thermique en contact avec le composant, soit rapportée sur le composant à refroidir, soit formée dans le substrat du composant à refroidir, cette surface étant destinée à extraire la chaleur générée dans le composant. Cette extraction, comme expliquée ci-dessus, s'effectue par un changement de phase par évaporation d'un liquide.

Le problème majeur au niveau de cette surface d'échange est le risque d'assèchement de la surface qui conduit à une diminution importante du coefficient d'échange thermique, et donc à une diminution de la quantité de chaleur évacuée. La paroi d'échange thermique voit alors sa température augmenter, ainsi que celle du composant, cette température peut alors devenir critique pour le composant.

L'assèchement correspond à un absence de liquide au niveau de la surface d'échange thermique, cela peut subvenir du fait de flux thermiques trop importants créant un bulle de vapeur bloquée dans un canal dans le cas d'un caloduc, la surface sur laquelle est bloquée la bulle ne voit plus de liquide, et l'extraction de la chaleur ne peut avoir lieu. Cela peut subvenir également par rupture du film liquide censé être réparti de manière homogène sur la surface intérieure du canal.

Par ailleurs, il a été montré que les surfaces mouillantes ont de très bonnes performances de transfert thermique en ébullition. Par exemple, dans le document Y. Takata, S. Hidaka, J.M. Cao, T. Nakamura, H. Yamamoto, M. Masuda, T. Ito, « Effect of surface wettability on boiling and evaporation », Energy 30 (2005) 209-220, il est montré qu'une surface hydrophile obtenue par dépôt de $TiO_2$ voit son coefficient d'échange thermique augmenté fortement, ainsi que son flux de chaleur critique par rapport à une surface non traitée.

Dans l'article S. Ujereh, T. Ficher, I. Mudawar, « Effects of carbon nanotube arrays on nucleate pool boiling », Int.J. of Heat and Mass Transfer 50 (2007) 4023-4038, les propriétés d'échange thermique de surfaces plus ou moins recouvertes de nanotubes de carbone ont été étudiées, il a été observé qu'une surface entièrement recouverte de nanotubes offre de meilleures performances thermiques par rapport aux surfaces partiellement recouvertes.

Le document S. Kim, H. Kim, H. D. Kim, H. S. Ahn, M. H. Kim, J. Kim, G. C. Park, « Experimental investigation of critical heat flux enhancement by micro/nanoscale surface modification in pool boiling", ICNMM2008, June 23-25, 2008, Darmstadt, Germany montre qu'une surface combinant des microstructures et des nanostructures permet de réduire l'angle de contact de 83° à 0° et d'augmenter le flux de chaleur critique de 200 %.

Les surfaces super mouillantes apparaissent donc comme particulièrement efficaces pour obtenir de bonnes performances thermiques. Cependant, plus la mouillabilité d'une surface est augmentée, plus l'énergie requise pour former les premiers germes de vapeur est élevée. Par conséquent la fréquence de formation de bulles de vapeur se trouve réduite dans le cas de surfaces mouillantes.

Par conséquent, c'est un but de la présente invention d'offrir un dispositif d'échange thermique aux performances améliorées, ou plus généralement une structure d'échange thermique dont l'efficacité est augmentée.

**EXPOSÉ DE L'INVENTION**

Le but précédemment énoncé est atteint par une surface comportant une structure micrométrique et une structure nanométrique superposée à la surface micrométrique, la structure micrométrique étant formée de cavités dont la surface intérieure présente une propriété de faible mouillabilité, et la zone inter-cavité présente une propriété de grande mouillabilité, la proportion de la surface intérieure des cavités par rapport à la surface totale étant faible.

Le fond et la paroi latérale des cavités sont donc propices à la génération de germes de vapeur, ces cavités étant bordées d'une surface facilitant le décrochement des bulles et le mouillage de la majeure partie de la surface d'échange thermique.

En d'autres termes, on réalise une surface offrant une hétérogénéité de structure avec une nanostructure recouvrant une microstructure, et une hétérogénéité physico-chimiques comportant des zones hydrophobes facilitant les germination de vapeur et des zones hydrophiles favorisant le décrochement des bulles et le remouillage.

Avantageusement, le fond et les parois des cavités présentent une faible hystérèse de mouillage inférieure à 15°, réduisant encore l'énergie d'activation de formation des germes.

Avantageusement, la répartition des cavités est de l'ordre de 1 à 100 cavités par $mm^2$.

La présente invention a alors pour objet une structure d'échange thermique comportant une face principale munie des trous non débouchants pratiqués dans cette face, ladite face munie des trous formant une microstructure, la surface intérieure des trous et la surface de ladite face principale à l'extérieur des trous étant telles qu'elles forment une nanostructure, l'intérieur des trous présentant un propriété de non-mouillabilité vis-à-vis d'un liquide donné et la surface de la face entre les trous présentant une propriété de mouillabilité vis-à-vis du liquide.

Dans un exemple préféré, les trous ont une dimension comprise entre 1 $\mu$m et 10 $\mu$m, et sont répartis sur la face de telle sorte qu'il y ait entre 1 trou/$mm^2$ et 100 trous/$mm^2$, et leur profondeur est comprise entre 1 $\mu$m et 10 $\mu$m.

La surface intérieure des trous présente avantageusement une faible hystérèse, par exemple inférieure à 15°.

La nanostructure est obtenue par dépôt de nanoparticules dont la taille peut être comprise entre 1 nm et 100 nm.

La présente invention a également pour objet un système de refroidissement comportant un évaporateur, un condenseur, et un fluide apte à passer d'un phase liquide à une phase vapeur au niveau de l'évaporateur et d'une phase vapeur à une phase liquide au niveau du condenseur, ledit évaporateur étant une structure d'échange thermique selon la présente invention. Il peut s'agir d'un caloduc, un réseau de capillaires ramenant le fluide en phase liquide du condenseur à l'évaporateur.

La présente invention a également pour objet un dispositif électronique ou micro-électronique comportant un système de refroidissement selon la présente invention, le système de refroidissement étant rapporté sur un substrat dudit dispositif ou intégré dans celui-ci.

La présente invention a également pour objet un dispositif embarqué ou portable comportant un système de refroidissement selon la présente invention.

La présente invention a également pour objet un procédé de fabrication d'une structure d'échange thermique selon la présente invention, comportant les phases de :

a) réalisation d'une microstructure comportant des trous non débouchants sur ou dans un substrat,
b) réalisation d'une nanostructure sur la microstructure,
c) traitement physico-chimique de la surface de sorte que la surface intérieure des trous soit non-mouillante et que la surface entre les trous soit mouillante.

Dans un exemple de réalisation, la phase a) comporte les étapes de :

- dépôt d'une couche sacrificielle sur un substrat,
- dépôt d'un masque dur sur la couche sacrificielle, celui-ci présentant une sélectivité de gravure importante par rapport au matériau de la couche sacrificielle,
- dépôt d'une couche de résine positive sur le masque dur,
- impression et révélation de trous,
- ouverture du masque dur,
- gravure de la couche sacrificielle,
- retrait de la couche de résine.

Par exemple, la couche sacrificielle est une couche de type DLC (« Diamond-like-carbon »).

Le masque dur peut être du $SiO_2$ ou SiC.

L'ouverture du masque peut se faire, par exemple par un plasma fluoré et la gravure de la couche sacrificielle par un plasma oxydant.

La phase b) peut comporter, par exemple le dépôt de nanoparticules sur toute la microstructure formée de la surface intérieure des trous et des zones inter-trous, le dépôt des nanoparticules formant une surface nanostructurée.

Quant à la phase c), celle-ci peut comporter :

c1) l'étape d'un traitement hydrophobe de toute la surface de la microstructure recouverte de la nanostructure,

c2) l'étape de traitement hydrophile des zones-inter-trous.

L'étape c1) est, par exemple réalisée par dépôt d'un film mince d'un matériau hydrophobe, tel que le SiOC.

L'épaisseur du film mince est avantageusement inférieure à la rugosité moyenne des la surface non-structurée.

Dans un exemple de réalisation, l'étape c2) peut être réalisée par une exposition à l'air du matériau hydrophobe et de balayage de la surface nanostructure par un rayon lumineux, par exemple un rayon laser, à l'exception de la surface intérieure des trous.

Dans un autre exemple de réalisation, l'étape c2) est réalisée par une exposition à l'air du matériau hydrophobe et de balayage de la surface nanostructure par un faisceau ultra-violet rasant, ce faisceau étant incliné par rapport à la surface de sorte à ne pas balayer la surface intérieure des trous.

## BRÈVE DESCRIPTION DES DESSINS

La présente invention sera mieux comprise à l'aide de la description qui va suivre et des dessins annexés sur lesquels :

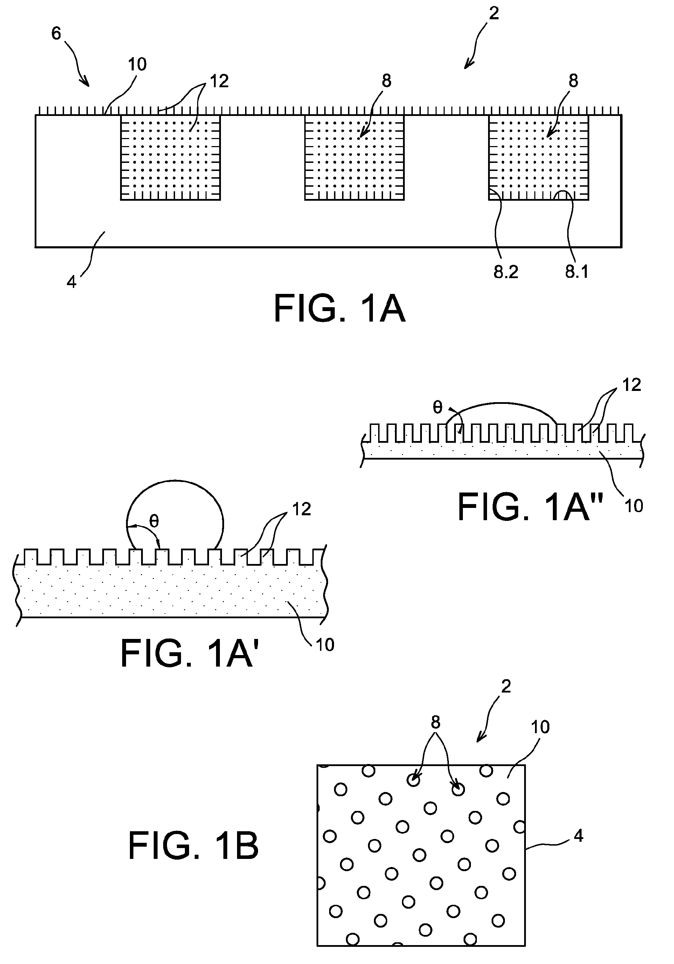

- la figure 1A est une vue en coupe d'une surface d'échange thermique selon la présente invention,
- les figures 1A' et 1A" sont des vues de détail de la figure 1A,
- la figure 1B est une vue de dessus de la surface de la figure 1A,
- les figures 2A à 2J sont des représentations schématiques de différentes étapes de réalisation d'une structure d'échange thermique selon la présente invention vue en coupe,
- la figure 2H' est une vue agrandie d'un détail de la figure 2H et la figure 2I' est une vue en perspective de la figure 2I,
- les figures 3A à 3E sont des représentations schématiques des différentes étapes de formation d'une bulle de vapeur sur une surface selon la présente invention,
- la figure 4 est une représentation schématique d'un caloduc selon la présente invention.

## EXPOSÉ DÉTAILLÉ DE MODES DE RÉALISATION PARTICULIERS

Dans la description qui va suivre, le liquide à évaporer sera une solution aqueuse, par conséquent on parlera de surface hydrophile ou hydrophobe. Mais il est bien entendu que la présente invention ne se limite pas à l'usage de solutions aqueuses, il peut s'agir par exemple d'huile, dans ce cas on parle de surface oléophile ou oléophobe. Plus généralement, on parlera de surfaces mouillantes ou non mouillantes.

Sur les figures 1A et 1B, on peut voir une partie d'une structure d'échange thermique 2 selon l'invention comportant une face principale 6 destinée à être disposée à l'opposé du composant à refroidir, est munie de trous 8, non débouchants dans l'autre face de la structure.

Dans l'exemple représenté, cette face principale est portée par une plaque plane 4.

La structure peut comporter une face principale de toute forme, concave, convexe, ou composée de surfaces planes, concaves et/ou convexes.

Les trous 8 comportent un fond 8.1 et une paroi latérale 8.2.

Dans l'exemple représenté, les trous 8 ont une section circulaire, mais des trous de toutes autres formes notamment parallélépipédique, en particulier de type carré ne sortent pas du cadre de la présente invention.

Le reste 10 de la face 6 non pourvue de trous et entourant les trous sera désigné par la suite « zone inter-trou » 10.

Typiquement, les trous ont un diamètre compris entre 1 $\mu$m et 10 $\mu$m, et leur répartition est de l'ordre de 1 trou/mm$^2$ à 100 trous/mm$^2$. La profondeur des trous est comprise entre 1 $\mu$m et 10 $\mu$m. Dans ces conditions de densité et taille de trou, la proportion de surface hydrophobe ou non mouillante est inférieure à environ 15%.

Les trous 8 forment ainsi une microstructure.

La structure d'échange thermique comporte également une nanostructure formée par des nanoparticules 12 recouvrant toute la face 4, plus particulièrement le fond 8.1 et la paroi latérale 8.2 des cavités sont recouvertes de nanoparticules, ainsi que les zones inter-trous 10. Les nanoparticules permettent d'augmenter la surface spécifique de la structure. Celles-ci ont un diamètre moyen compris entre 1 et 100 nm.

Les nanoparticules sont par exemple réalisées en métal, en alliage métallique, en argent, en cuivre ou en Fe$_2$O$_3$, en oxyde de silicium ou en polymère.

Selon la présente invention, les trous 8, plus particulièrement le fond 8.1 et la paroi 8.2 de chaque trou, sont non mouillants ou présentent une propriété hydrophobe vis-à-vis d'un liquide 16 donné, par exemple de l'eau, et les zones inter-trous 10 sont mouillantes vis-à-vis du liquide 16.

Le fond 8.1 et les trous 8.2 présentent un non-mouillage supérieur à celui d'une surface non nanostructurée, tandis que les zones inter-trou présentent offre un mouillage supérieur à celui d'une surface non nanostructurée.

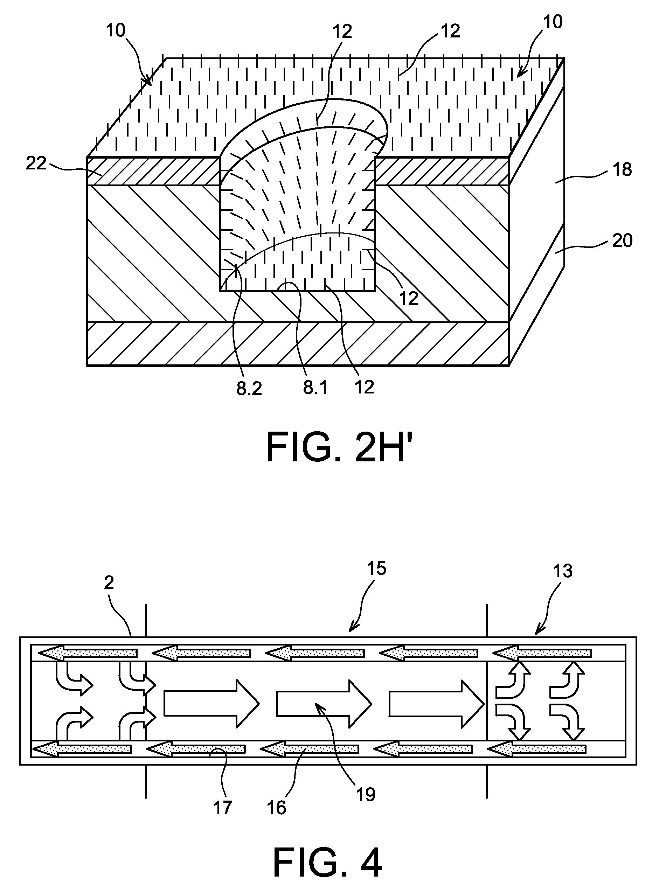

Sur la figure 4, on peut voir un caloduc comportant une structure 2 selon la présente invention formant l'évaporateur, il comporte également un condenseur 13 et une zone adiabatique 15. La zone adiabatique 15 est formée d'un réseau capillaire 17 qui sert de moteur au caloduc en ramenant le fluide sous forme liquide 16 condensé vers l'évaporateur. Les flèches 19 symbolisent le fluide sous forme vapeur 19.

De manière équivalente à l'art antérieur, un caloduc selon l'invention peut prendre diverses formes (tubes, serpentins) en rapport avec la surface du composant à refroidir. En particulier, il possède une longueur de quelques millimètres à quelques centimètres, tandis que la section de la conduite du caloduc, qui peut être de formes variées (carrée rectangulaire, triangulaire...) est dimensionnée à hauteur du millimètre ou moins, plus préférentiellement de l'ordre du dixième de millimètre.

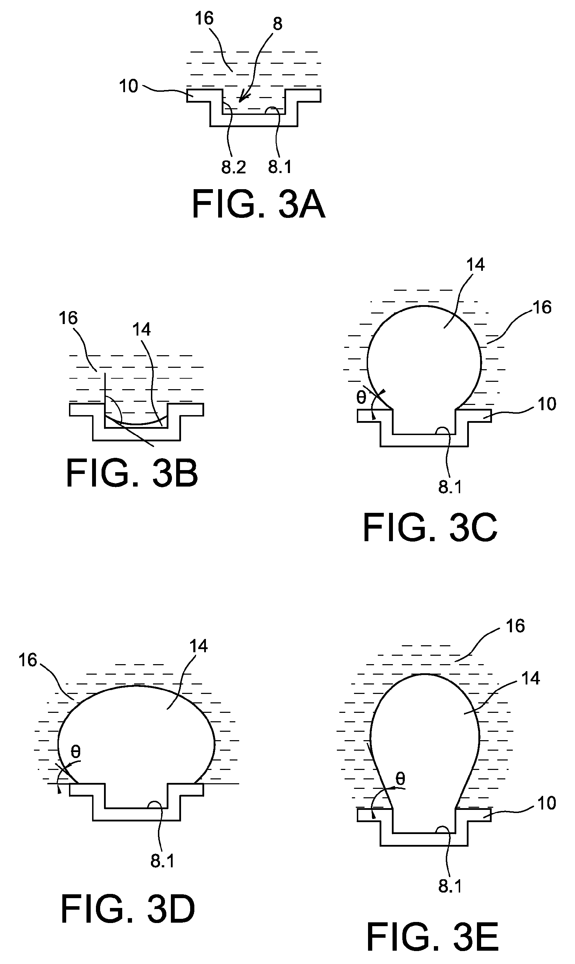

Nous allons maintenant expliquer le processus de génération de vapeur grâce à la structure d'échange thermique 2 selon l'invention au moyen des figures 3A à 3E.

On peut voir un trou 8 entouré de la zone inter-trou 10.

Le liquide 16, ici de l'eau, recouvre le trou et la zone inter-trou.

Sur la figure 1A', on peut voir une vue agrandie du fond 8.1 de la cavité, l'eau recouvre le haut des nanoparticules piégeant de l'air entre les nanoparticules 12. Cette représentation correspond à un état super-hydrophobe de Cassie.

Sur la figure 1A", on peut voir une vue agrandie de la zone inter-trou 10 hydrophile, l'eau recouvre les nanoparticules et remplit les espaces entre les nanoparticules. Cette représentation correspond à un état super-hydrophile de Cassie.

Les nanoparticules déposées sur le fond 8.1 et sur la paroi 8.2 du trou 8 forment des sites de nucléation hydrophobes remplis d'air dans lesquels de la vapeur est en équilibre avec le liquide. L'énergie d'activation de formation des germes de vapeur est alors réduite. Par conséquent, ceux-ci apparaissent plus facilement que sur une surface hydrophile. En outre, du fait de la très grande surface spécifique, le nombre de sites de nucléation est très grand. La génération d'un grand nombre de germes de vapeur est donc facilitée, ceux-ci vont former, en se regroupant, un début de bulle de vapeur 14 (figure 3B).

On favorise en fait la formation de films de vapeur dans les trous. Cependant ces trous représentent une surface relativement faible par rapport à la surface totale de la structure et donc par rapport à la surface hydrophile, sur laquelle on facilite le mouillage. L'assèchement localisé ne peut alors provoquer une élévation de la température du composant à refroidir.

La bulle de vapeur 14 va ensuite grossir (figure 3C). La zone inter-tour étant hydrophile, l'angle de contact θ à l'interface liquide-vapeur est inférieur à 90°.

La bulle de vapeur, au fur et à mesure de son expansion, déborde du trou et vient en contact avec la partie de la zone inter-trou entourant le trou, il y a alors un début d'assèchement de la zone inter-trou.

Cependant, du fait des forces de capillarité, le point triple est repoussé vers la cavité assurant un remouillage de la zone inter-trou.

Enfin la bulle se détache.

Il y a ensuite un remouillage immédiat du trou 8, ce qui permet d'augmenter la fréquence de germination.

La propriété hydrophile de la zone inter-trou permet un détachement des bulles de vapeur et le remouillage de la zone inter-trou. On évite ainsi l'apparition d'un film de vapeur qui empêcherait l'extraction de la chaleur.

Grâce à l'invention, on obtient à la fois une germination facilitée par la nanostructure hydrophobes, et une ébullition et un remouillage facilités par la microstructure hydrophile.

Nous allons maintenant décrire un procédé de fabrication d'une telle structure d'échange thermique.

La structure peut être réalisée directement dans le matériau constituant le substrat, par exemple en silicium, en aluminium ou en acier, ou dans une couche sacrificielle déposée préalablement en faible épaisseur sur le substrat.

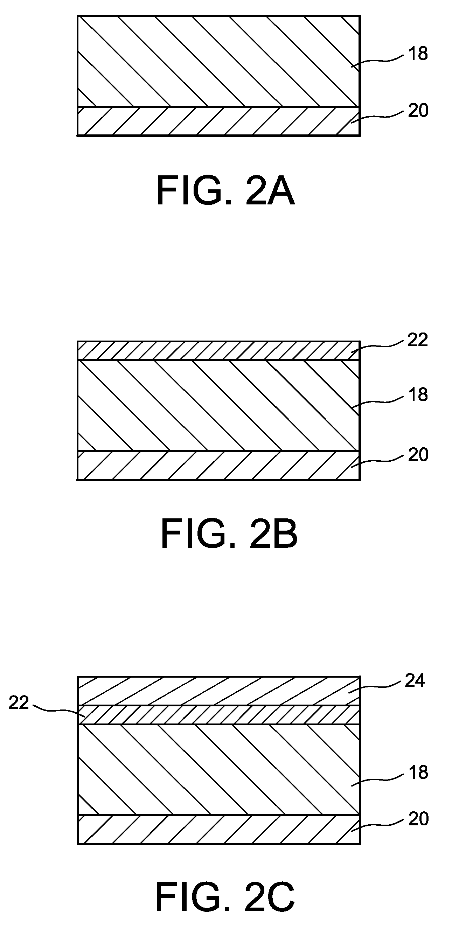

Nous décrirons en détail cette deuxième possibilité en utilisant une couche sacrificielle de type DLC (« Diamond-like-carbon »). Les figures 2A à 2I sont des vues en coupes schématiques d'un détail de la structure selon l'invention au niveau d'un trou 8 lors de ses différentes étapes de réalisation.

On peut distinguer trois phases dans le procédé de fabrication selon l'invention, une phase de microstructuration, une phase de nanostructuration et une phase de traitement physico-chimique.

Tout d'abord a lieu la phase de microstructuration.

Sur la figure 2A, on peut voir une première étape de dépôt d'une couche sacrificielle 18 sur le substrat 20, par exemple en silicium, en acier ou en aluminium. La couche sacrificielle 18 peut être déposée par dépôt chimique en phase vapeur assisté par plasma (PECVD pour "Plasma Enhanced Chemical Vapor Deposition").

La couche sacrificielle 18 est déposée uniformément et conformément sur le substrat, sur une épaisseur comprise entre 500 nm et 2 μm. Cette couche est prévue de sorte à être suffisamment fine et adhésive pour ne pas altérer le transfert thermique du substrat 20.

La couche sacrificielle peut être également obtenue à partir d'un dépôt en couche mince d'un matériau offrant un bon compromis entre son aptitude à être gravée par plasma et ses propriétés thermiques. Ce matériau peut être du silicium, de l'oxyde de silicium, du nitrure de silicium ou du carbure de silicium, un métal comme l'aluminium ou le cuivre.

Lors d'une étape suivante représentée sur la figure 2B, on effectue un dépôt d'un masque dur 22 sur la couche sacrificielle 18. Le masque 22 a, par exemple une épaisseur comprise entre 50 nm et 200 nm. Le matériau du masque 22 présente une sélectivité de gravure importante vis-à-vis de la couche sacrificielle, plus particulière vis-à-vis de la couche DLC en condition de plasma oxydant. Par exemple ce masque est en en oxyde de silicium SiO$_2$, en carbure de silicium, en nitrure de silicium ou en métal. Le masque 22 peut également être déposé par PECVD.

Dans une étape suivante représentée sur la figure 2C, on effectue un dépôt d'une couche de photo-résine 24 d'épaisseur comprise entre 0,5 μm et 2 μm.

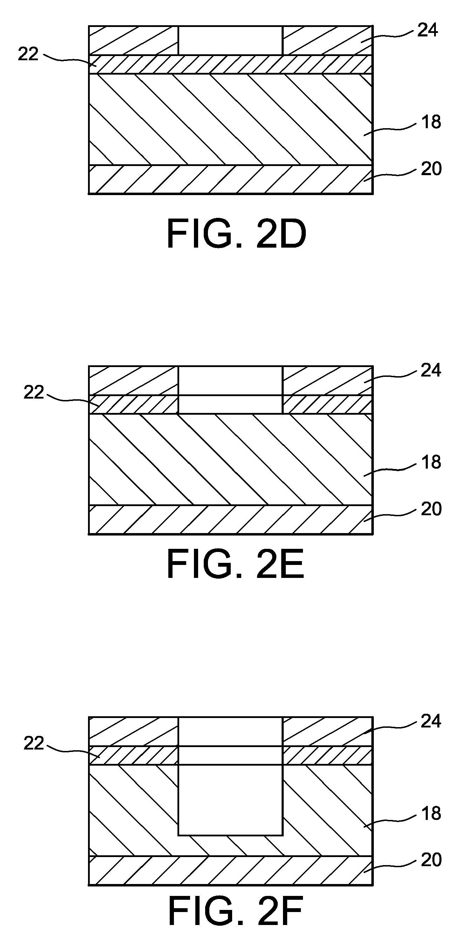

Lors d'une étape suivante représentée sur la figure 2D, on effectue une impression et une révélation des trous 8 par laser ou photolithographie conventionnelle. Les trous ainsi formés ont un diamètre compris entre 1 μm et 10 μm. Ces trous peuvent être, comme déjà expliqué précédemment, de toute forme, par exemple carrée. Leur densité est comprise entre 1 trou/mm$^2$ et 100 trous/mm$^2$. Les dimensions des trous sont choisies sur la base du rayon critique d'un site de nucléation qui est le rayon minimal stable permettant la croissance de la bulle et de la longueur d'onde de Taylor pour l'eau dont les expressions mathématiques sont les suivantes :

$$- \quad r_c = \frac{2\sigma T_{sat}}{\rho_v \, h_{lv} \, (T_p - T_{sat})} \, ,$$

et

$$- \lambda_T = 2\pi \left[ \frac{\sigma}{g(\rho l - \rho_v)} \right]^{1/2}$$

Avec

- r$_c$ le rayon critique d'un site de nucléation,
- λ$_T$ la longueur d'onde de Taylor pour l'eau,
- σ la tension superficielle du liquide,
- ρ$_l$ et ρ$_v$ les masses volumiques du liquide et de la vapeur respectivement,
- h$_{lv}$ la chaleur latente,
- T$_p$ et T$_{sat}$ la température de la paroi et la température de saturation.

Lors d'une étape suivante représentée sur la figure 2E, le masque dur 22 est ouvert par un plasma fluoré pour découvrir la couche sacrificielle 18 en DLC.

Lors d'une autre étape représentée sur la figure 2F, la couche sacrificielle 18 est gravée par plasma oxydant.

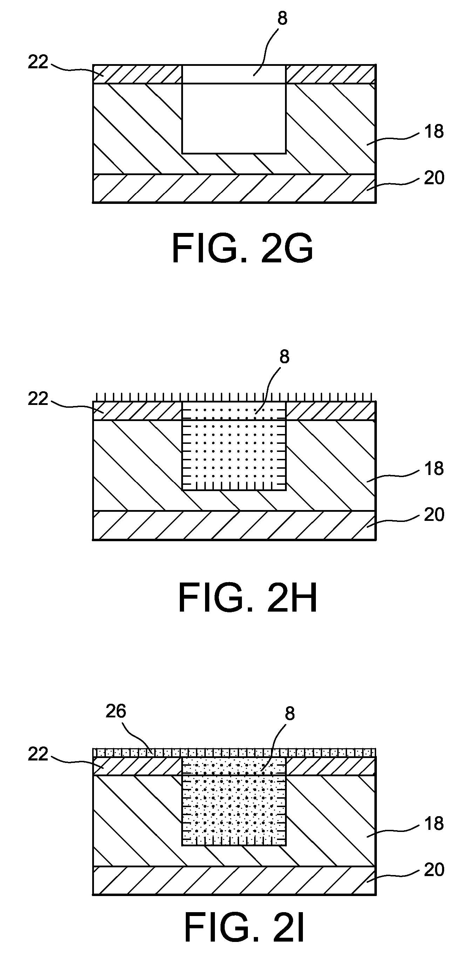

Lors de l'étape représentée sur la figure 2G, on retire la couche de photo-résine 24 par immersion dans un solvant.

A ensuite lieu la phase de nanostructuration, lors de laquelle sont déposées des nanoparticules 12 de manière uniforme et conforme sur la surface obtenue lors de l'étape représentée à la figure 2F. Ce dépôt est représenté sur la figure 2H et sur la figure 2H' en perspective, on voit le dépôt des nanoparticules sur le fond 8.1 et la paroi 8.2 du trou 8 et sur les zones inter-trou 10..

Les nanoparticules 12 ont un diamètre moyen compris entre 1 nm et 150 nm.

Ces particules peuvent être formées à partir de matériaux divers déposés par différentes techniques. Comme indiqué précédemment, ces nanoparticules sont destinées à augmenter la surface spécifique de la structure afin d'augmenter le mouillage ou le non-mouillage qui sera induit par les étapes suivantes.

Ces particules peuvent être des nanotubes de carbone obtenus par les techniques habituelles.

Il peut s'agir de nanoparticules métalliques ou en alliage métallique dont la taille est comprise entre 1 nm et 10 nm, déposées par procédé Mantis. On peut prévoir des dépôts de nanoparticules d'argent, de platine de cuivre, de Fe2O3 par procédé DLI, par MOCBVD ou MPA. On peut également envisager des dépôts d'oxyde de silicium ou de polymères dont la taille est inférieure à 100 nm par procédé nanometrix.

A ensuite lieu la phase de traitement physico-chimique.

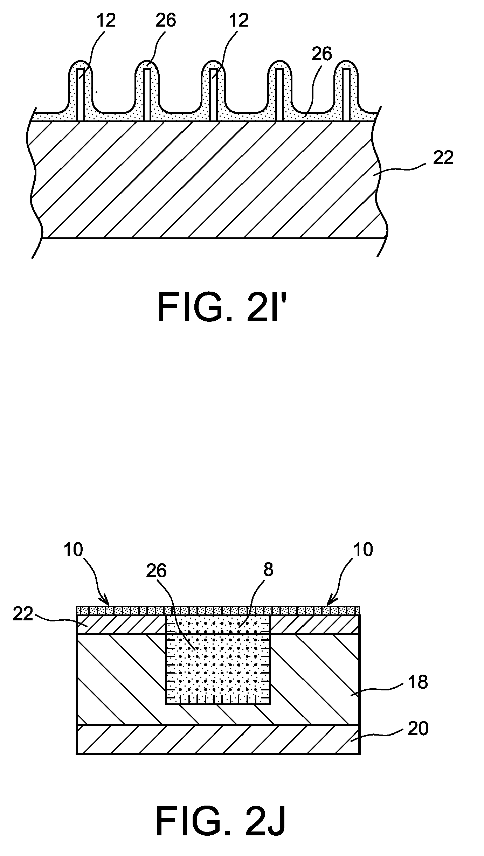

Lors de l'étape représentée sur la figure 2I, on effectue un dépôt d'un film en matériau hydrophobe 26 d'une épaisseur suffisante pour couvrir uniformément la surface mais sans effacer la topographie engendrée par les nanoparticules (épaisseur typiquement inférieure à 10 nm), ce matériau offre avantageusement une faible hystérèse de mouillage, de préférence inférieure à 15°, sur toute la surface de la structure. Le SiOC offre une telle propriété. Le dépôt 26 est suffisamment fin pour que la nanotexturation des trous 8 puisse jouer son rôle. Sur la figure 2I' qui est une vue agrandie de la figure 2I, on peut voir les nanoparticules 12 sur une zone inter-trou 10 recouverte du film 26 ; on voit que le film recouvre individuellement les nanoparticules 12 sans les noyer, la nanostructuration est donc conservée.

Le téflon est également envisageable bien qu'il ait une hystérèse de mouillage comprise entre 20° et 40°.

Le dépôt de cette couche hydrophobe peut être effectué par PECVD. L'épaisseur du film mince 26 (représenté schématiquement en grisé sur la figure 2I) est inférieure à la rugosité moyenne de la surface du fond 8.1 et de la 8.2 sur lesquelles les nanoparticules 12 ont été déposées, afin de conserver une surface spécifique importante. A des fins d'illustration, l'épaisseur du film 26 tel que représenté sur la figure 2I est bien supérieure à son épaisseur réelle. Le film 26 recouvre chacune des nanoparticules sans les noyer contrairement à la représentation, conservant ainsi la nanostructuration de la surface.

Lors d'une étape ultérieure (figure 2J), on traite les surfaces inter-trous 10 de sorte à les rendre hydrophiles (représentées sous forme de quadrillés sur la figure 2J) tout en préservant la propriété hydrophobe de la surface intérieure des trous (en grisée sur la figure 2J).

Ce traitement hydrophile peut être réalisé en exposant le film 26 de SiOC à l'air et au balayage d'un faisceau lumineux conduisant à son oxydation et à la formation de groupes fonctionnelles hydrophiles, par exemple OH ou hydroxyles. Le balayage n'inclut par les trous 8. Le faisceau lumineux peut être un laser.

On peut également effectuer ce traitement en exposant le SiOC à l'air sous un faisceau rasant d'ultraviolet conduisant à la formation de groupes hydrophiles, comme précédemment. L'inclinaison du faisceau permet de protéger l'intérieur des trous de la réaction d'oxydation et de conserver le pouvoir hydrophobe des trous.

La structure d'échange thermique selon la présente invention est donc particulièrement adaptée pour être utilisée dans des systèmes de refroidissement, comme les caloducs, les thermosiphons et les systèmes de pompage de type diphasique, cette structure formant l'évaporateur.

Par exemple dans le cas d'un caloduc, la structure selon l'invention peut former une partie du fond des capillaires destinés à ramener le liquide du condenseur à l'évaporateur.

La présente invention peut être appliquée dans des domaines ayant des besoins de refroidissement avec des flux importants et dans lesquels l'encombrement est rédhibitoire.

Par exemple, la présente invention est particulièrement adaptée au domaine de l'électronique de puissance dans lequel la densité de flux thermique peut atteindre 1000 W/cm$^2$, au domaine de la micro-électronique, par exemple pour le refroidissement des micro-puces, l'équipement embarqué, comme dans l'aéronautique civile et militaire et dans l'industrie spatial, et dans les systèmes nomades, par exemple pour le refroidissement des composants pour téléphones portables, des disques durs externes...

## Revendications

1.  Structure d'échange thermique comportant une face principale (6) munie des trous non débouchants (8) pratiqués dans cette face (6), ladite face (6) munie des trous (8) formant une microstructure, la surface intérieure des trous (8) étant telle qu'elle forme une nanostructure, **caractérisée en ce que** la surface (10) de ladite face principale (4) à l'extérieur des trous (8) est telle qu'elle forme une nanostructure, l'intérieur des trous (8) présentant un propriété de non-mouillabilité vis-à-vis d'un liquide donné et la surface (10) de la face principale (4) entre les trous présentant une propriété de mouillabilité vis-à-vis du liquide.

2.  Structure d'échange thermique selon la revendication 1, dans laquelle les trous (8) ont une dimension comprise entre 1 μm et 10 μm, une profondeur comprise entre 1 μm et 10 μm et sont répartis sur la face principale (6) de telle sorte qu'il y ait entre 1 trou/mm$^2$ et 100 trous/mm$^2$.

3.  Structure d'échange thermique selon la revendication 1 ou 2, dans laquelle le rapport entre la surface hydrophobe et la surface totale est inférieur à environ 15%.

4.  Structure d'échange thermique selon la revendication 1, 2 ou 3, dans laquelle la surface intérieure des trous (8) présente une faible hystérèse, par exemple inférieure à 15°.

5.  Structure d'échange thermique selon l'une des revendications 1 à 4, dans laquelle la nanostructure est obtenue par le dépôt de nanoparticules (12) dont la taille est comprise entre 1 nm et 100 nm.

6.  Système de refroidissement comportant un évaporateur, un condenseur, et un fluide apte à passer d'une phase liquide à une phase vapeur au niveau de l'évaporateur et d'une phase vapeur à une phase liquide au niveau du condenseur (13), ledit évaporateur étant une structure d'échange thermique (2) selon l'une quelconque des revendications précédentes.

7.  Système de refroidissement selon la revendication précédente formant un caloduc, un réseau de capillaires (17) ramenant le fluide en phase liquide du condenseur (15) à l'évaporateur (4).

8.  Dispositif électronique ou micro-électronique comportant un système de refroidissement selon la revendication 6 ou 7, le système de refroidissement étant rapporté sur un substrat dudit dispositif ou intégré dans celui-ci.

9.  Dispositif embarqué ou portable comportant un système de refroidissement selon la revendication 6 ou 7

10. Procédé de fabrication d'une structure d'échange thermique (2) selon l'une des revendications 1 à 5, comportant les phases de :

    a) réalisation sur ou dans un susbsrat d'une microstructure comportant des trous non débouchants (8),
    b) réalisation d'une nanostructure sur la microstructure,
    c) traitement physico-chimique de la surface de sorte que la surface intérieure des trous (8) soit non-mouillante et que la surface (10) entre les

11. Procédé de fabrication d'une structure d'échange thermique selon la revendication précédente, dans lequel la phase a) comporte les étapes de :

- dépôt d'une couche sacrificielle (18) sur un substrat (20),
- dépôt d'un masque dur (22) sur la couche sacrificielle (18), celui-ci présentant une sélectivité de gravure importante par rapport au matériau de la couche sacrificielle (18),
- dépôt d'une couche de résine positive (24) sur le masque dur (22),
- impression et révélation de trous (8),
- ouverture du masque dur (22),
- gravure de la couche sacrificielle (18),
- retrait de la couche de résine (24).

12. Procédé de fabrication d'une structure d'échange thermique selon la revendication précédente, dans lequel la couche sacrificielle (18) est une couche de type DLC (« Diamond-like-carbon »).

13. Procédé de fabrication d'une structure d'échange thermique selon la revendication 11 ou 12, dans lequel le masque dur (22) est du $SiO_2$ ou en SiC.

14. Procédé de fabrication d'une structure d'échange thermique selon l'une des revendications 11 à 13, dans lequel l'ouverture du masque (22) se fait par un plasma fluoré et la gravure de la couche sacrificielle (18) par un plasma oxydant.

15. Procédé de fabrication d'une structure d'échange thermique selon l'une des revendications 10 à 14, dans lequel la phase b) comporte le dépôt de nanoparticules (12) sur toute la microstructure formée de la surface intérieure des trous (8) et des zones inter-trous (10), le dépôt des nanoparticules (12) formant une surface nano-structurée.

16. Procédé de fabrication d'une structure d'échange thermique selon l'une des revendications 10 à 15, dans lequel la phase c) comporte :

c1) l'étape d'un traitement hydrophobe de toute la surface de la microstructure recouverte de la nanostructure,
c2) l'étape de traitement hydrophile des zones-inter-trous (10).

17. Procédé de fabrication d'une structure d'échange thermique selon la revendication précédente, dans lequel l'étape c1) est réalisée par dépôt d'un film mince (26) d'un matériau hydrophobe, tel que le SiOC.

18. Procédé de fabrication d'une structure d'échange thermique selon la revendication précédente, dans lequel l'épaisseur du film (26) est inférieure à la rugosité moyenne de la surface non-structurée.

19. Procédé de fabrication d'une structure d'échange thermique selon l'une des revendications 16 à 18, dans lequel l'étape c2) est réalisée par une exposition à l'air du matériau hydrophobe et de balayage de la surface nanostructure par un rayon lumineux, par exemple un rayon laser, à l'exception de la surface intérieure des trous (8), ou par un faisceau ultraviolet rasant, ce faisceau étant incliné par rapport à la surface de sorte à ne pas balayer la surface intérieure des trous (8).

**Patentansprüche**

1. Wärmetauscherstruktur, umfassend eine Hauptfläche (6), welche mit nicht durchgehenden Löchern (8) bereitgestellt ist, welche in der Fläche (6) vorgesehen sind, wobei die mit Löchern (8) bereitgestellte Fläche (6) eine Mikrostruktur bildet, wobei die Innenoberfläche der Löcher (8) derart ist, sie eine Nanostruktur bildet, **dadurch gekennzeichnet, dass** die Oberfläche (10) der Hauptfläche (6) außerhalb der Löcher (8) derart ist, dass sie eine Nanostruktur bildet, wobei das Innere der Löcher (8) eine Eigenschaft einer Nicht-Benetzbarkeit gegenüber einer gegebenen Flüssigkeit aufweist und die Oberfläche (10) der Hauptfläche (4) zwischen den Löchern eine Eigenschaft einer Benetzbarkeit gegenüber der Flüssigkeit aufweist.

2. Wärmetauscherstruktur nach Anspruch 1, wobei die Löcher (8) eine Abmessung aufweisen, welche zwischen 1 μm und 10 μm liegt, eine Tiefe, welche zwischen 1 μm und 10 μm liegt, und derart an der Hauptfläche (6) verteilt sind, dass zwischen 1 Loch/mm$^2$ und 100 Löchern/mm$^2$ vorliegen.

3. Wärmetauscherstruktur nach Anspruch 1 oder 2, wobei das Verhältnis zwischen der hydrophoben Oberfläche und der gesamten Oberfläche kleiner als etwa 15% ist.

4. Wärmetauscherstruktur nach Anspruch 1, 2 oder 3, wobei die Innenoberfläche der Löcher (8) eine schwache Hysterese aufweist, beispielsweise kleiner als 15°.

5. Wärmetauscherstruktur nach einem der Ansprüche 1 bis 4, wobei die Nanostruktur durch Anlagern von Nanopartikeln (12) erhalten wird, deren Größe zwischen 1 nm und 100 nm beträgt.

**6.** Kühlsystem, umfassend einen Verdampfer, einen Kondensator und ein Fluid, welches in der Lage ist, auf dem Niveau des Verdampfers von einer flüssigen Phase in eine Dampfphase überzugehen und auf dem Niveau des Kondensators (13) von einer Dampfphase in eine flüssige Phase überzugehen, wobei der Verdampfer eine Wärmetauscherstruktur (2) nach einem der vorhergehenden Ansprüche ist.

**7.** Kühlsystem nach dem vorhergehenden Anspruch, welches ein Wärmerohr bildet, wobei ein Netz von Kapillaren (17) das Fluid in flüssiger Phase von dem Kondensator (15) zu dem Verdampfer (4) zurückführt.

**8.** Elektronische oder mikroelektronische Vorrichtung, umfassend ein Kühlsystem nach Anspruch 6 oder 7, wobei das Kühlsystem an einem Substrat der Vorrichtung angeordnet oder darin integriert ist.

**9.** Eingebettete oder tragbare Vorrichtung, umfassend ein Kühlsystem nach Anspruch 6 oder 7.

**10.** Verfahren zum Herstellen einer Wärmetauscherstruktur (2) nach einem der Ansprüche 1 bis 5, umfassend die Phasen:

a) Bilden einer nicht durchgehende Löcher (8) umfassenden Mikrostruktur an oder in einem Substrat,
b) Bilden einer Nanostruktur an der Mikrostruktur,
c) physikalisch-chemisches Behandeln der Oberfläche derart, dass die Innenoberfläche der Löcher (8) nicht-benetzbar wird, und dass die Oberfläche (10) zwischen den Löchern (8) benetzbar wird.

**11.** Verfahren zum Herstellen einer Wärmetauscherstruktur nach dem vorhergehenden Anspruch, wobei die Phase a) die Schritte umfasst:

- Anlagern einer Opferschicht (18) an einem Substrat (20),
- Anlagern einer festen Maske (22) an der Opferschicht (18), welche bezüglich dem Material der Opferschicht (18) eine hohe Ätz-Selektivität aufweist,
- Anlagern einer positiven Harzschicht (24) an der festen Maske (22),
- Drucken und Freilegen der Löcher (8),
- Öffnen der festen Maske (22),
- Ätzen der Opferschicht (18),
- Abtragen der Harzschicht (24).

**12.** Verfahren zum Herstellen einer Wärmetauscherstruktur nach dem vorhergehenden Anspruch, wobei die Opferschicht (18) eine Schicht vom DLC-Typ (<< Diamond-like-carbon>>) ist.

**13.** Verfahren zum Herstellen einer Wärmetauscherstruktur nach Anspruch 11 oder 12, wobei die feste Maske (22) aus $SiO_2$ oder aus SiC ist.

**14.** Verfahren zum Herstellen einer Wärmetauscherstruktur nach einem der Ansprüche 11 bis 13, wobei das Öffnen der Maske (22) durch ein flouoriertes Plasma und das Ätzen der Opferschicht (18) durch ein oxidierendes Plasma vorgenommen wird.

**15.** Verfahren zum Herstellen einer Wärmetauscherstruktur nach einem der Ansprüche 10 bis 14, wobei die Phase b) das Anlagern von Nanopartikeln (12) auf der gesamten Mikrostruktur umfasst, welche durch die Innenoberfläche der Löcher (8) und die Zonen (10) zwischen den Löchern gebildet ist, wobei das Anlagern der Nanopartikel (12) eine nano-strukturierte Oberfläche bildet.

**16.** Verfahren zum Herstellen einer Wärmetauscherstruktur nach einem der Ansprüche 10 bis 15, wobei die Phase c) umfasst:

c1) den Schritt eines hydrophoben Behandelns der gesamten Oberfläche der mit der Nanostruktur bedeckten Mikrostruktur,
c2) den Schritt eines hydrophilen Behandelns der Zonen (10) zwischen den Löchern.

**17.** Verfahren zum Herstellen einer Wärmetauscherstruktur nach dem vorhergehenden Anspruch, wobei der Schritt c1) durch Anlagern eines dünnen Films (26) eines hydrophoben Materials wie SiOC durchgeführt wird.

**18.** Verfahren zum Herstellen einer Wärmetauscherstruktur nach dem vorhergehenden Anspruch, wobei die Dicke des Films (26) kleiner ist als die mittlere Rauheit der nicht-strukturierten Oberfläche.

**19.** Verfahren zum Herstellen einer Wärmetauscherstruktur nach einem der Ansprüche 16 bis 18, wobei der Schritt c2) durch ein Aussetzen des hydrophoben Materials an die Luft und ein Abtasten der Nanostruktur-Oberfläche durch einen Lichtstrahl, beispielsweise einen Laserstrahl, mit Ausnahme der Innenfläche der Löcher (8) durchgeführt wird, oder durch ein streifendes Ultraviolett-Strahlenbündel, welches Strahlenbündel bezüglich der Oberfläche derart geneigt ist, dass die Innenoberfläche der Löcher (8) nicht abgetastet wird.

**Claims**

**1.** A heat exchange structure comprising a primary face (6) provided with non-through holes (8) formed in said face (6), said face (6) provided with holes (8) forming a microstructure, the inner surface of the holes (8) and the surface (10) of said primary face (4) outside the holes (8) being such that they form a nanostructure, **characterized in that** the surface (10) of said primary face (6) outside the holes (8) is such that it forms a nanostructure, the inside of the holes (8) having a non-wettability property relative to a given liquid and the surface (10) of the primary face (4) between the holes having a wettability property relative to the liquid.

2. The heat exchange structure according to claim 1, wherein the holes (8) have a dimension between 1 μm and 10 μm, a depth between 1 μm and 10 μm and are distributed on the primary face (6) such that there is between 1 hole/mm$^2$ and 100 holes/mm$^2$.

3. The heat exchange structure according to claim 1 or 2, wherein the ratio between the hydrophobic surface and the total surface is less than about 15%.

4. The heat exchange structure according to claim 1, 2 or 3, wherein the inner surface of the holes (8) has a low hysteresis, for example less than 15°.

5. The heat exchange structure according to one of claims 1 to 4, wherein the nanostructure is obtained by depositing nanoparticles (12) whereof the size is between 1 nm and 100 nm.

6. A cooling system comprising an evaporator, a condenser, and a fluid capable of going from a liquid phase to a vapor phase at the evaporator and a vapor phase to a liquid phase at the condenser (13), said evaporator being a heat exchange structure (2) according to any one of the preceding claims.

7. The cooling system according to the preceding claim forming a heat pipe, an array of capillaries (17) bringing the fluid in liquid phase from the condenser (15) to the evaporator (4).

8. An electronic or microelectronic device comprising a cooling system according to claim 6 or 7, the cooling system being attached on a substrate of said device or integrated therein.

9. An onboard or portable device comprising a cooling system according to claim 6 or 7.

10. A method for making a heat exchange structure (2) according to one of claims 1 to 5, comprising the following phases:

a) making a microstructure comprising non-through holes (8) on or in a substrate,

b) making a nanostructure on the microstructure,
c) physicochemical treatment of the surface such that the inner surface of the holes (8) is non-wetting and the surface (10) between the holes (8) is wetting.

11. The method for making a heat exchange structure according to the preceding claim, wherein phase a) comprises the following steps:

- depositing a sacrificial layer (18) on a substrate (20),
- depositing a hard mask (22) on the sacrificial layer (18), the latter having a high etching selectivity relative to the material of the sacrificial layer (18),
- depositing a positive resin layer (24) on the hard mask (22),
- printing and revealing holes (8),
- opening the hard mask (22),
- etching the sacrificial layer (18),
- removing the layer of resin (24).

12. The method for making a heat exchange structure according to the preceding claim, wherein the sacrificial layer (18) is a DLC ("Diamond-like-carbon") layer.

13. The method for making a heat exchange structure according to claim 11 or 12, wherein the hard mask (22) is made from SiO$_2$ or SiC.

14. The method for making a heat exchange structure according to one of claims 11 to 13, wherein the mask (22) is opened by a fluorinated plasma and the etching of the sacrificial layer (18) is done using an oxidizing plasma.

15. The method for making a heat exchange structure according to one of claims 10 to 14, wherein phase b) comprises the deposition of nanoparticles (12) over the entire microstructure formed from the inner surface of the holes (8) and inter-hole areas (10), the deposition of nanoparticles (12) forming a nanostructured surface.

16. The method for making a heat exchange structure according to one of claims 10 to 15, wherein phase c) comprises:

c1) a step for a hydrophobic treatment of the entire surface of the microstructure covered by the nanostructure,
c2) a step for a hydrophilic treatment of the inter-hole areas (10).

17. The method for making a heat exchange structure according to the preceding claim, wherein step c1) is done by depositing a thin film (26) of a hydrophobic material, such as SiOC.

18. The method for making a heat exchange structure according to the preceding claim, wherein the thickness of the film (26) is smaller than the average rouahness of the non-structured surface.

19. The method for making a heat exchange structure according to one of claims 16 to 18, wherein step c2) can be done by exposing the hydrophobic material to air and scanning the nanostructure surface with a light ray, for example a laser beam, with the exception of the inner surface of the holes (8) or with a raking ultraviolet beam, said beam being inclined relative to the surface so as not to scan the inner surface of the holes (8).

FIG. 1A

FIG. 1A"

FIG. 1A'

FIG. 1B

FIG. 2A

FIG. 2B

FIG. 2C

FIG. 2D

FIG. 2E

FIG. 2F

FIG. 2G

FIG. 2H

FIG. 2I

12    26    12    26

22

## FIG. 2I'

10    10
26    8
22
18
20

## FIG. 2J

FIG. 2H'

FIG. 4

FIG. 3A

FIG. 3B

FIG. 3C

FIG. 3D

FIG. 3E

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LORA KAMENOVA ; YVAN AVENAS ; NATHALI-YA POPOVA ; CHRISTIAN SCHAEFFER ; SLAV-KA TZANOVA.** Conception and test of flat heat pipe for 3D packaging cooling. IEEE, 787-792
- **Y. TAKATA ; S. HIDAKA ; J.M. CAO ; T. NAKAMURA ; H. YAMAMOTO ; M. MASUDA ; T. ITO.** Effect of surface wettability on boiling and evaporation. *Energy,* 2005, vol. 30, 209-220

- **S. UJEREH ; T. FICHER ; I. MUDAWAR.** Effects of carbon nanotube arrays on nucleate pool boiling. *Int.J. of Heat and Mass Transfer,* 2007, vol. 50, 4023-4038
- **S. KIM ; H. KIM, ; H. D. KIM ; H. S. AHN ; M. H. KIM ; J. KIM ; G. C. PARK.** Experimental investigation of critical heat flux enhancement by micro/nanoscale surface modification in pool boiling. *ICNMM2008,* 23 Mai 2008